# EUROPEAN PATENT APPLICATION

(11) **EP 4 761 558 A1**
(43) Date of publication of application: **17.06.2026**
(21) Application number: 25222594.1
(22) Date of filing: 11.12.2025
(51) Int. Cl.: H10W 20/00, H10W 20/41, H10W 20/44

(54) **INTERCONNECT STRUCTURE, ELECTRONIC DEVICE INCLUDING THE SAME, AND ELECTRONIC APPARATUS INCLUDING THE SAME**

(30) Priority: 12.12.2024 KR 20240185163
(71) Applicant: Samsung Electronics Co., Ltd., Suwon-si, Gyeonggi-do 16677 (KR)
(72) Inventor: Jo, Giyoung, 16678 Suwon-si, Gyeonggi-do (KR); Han, Yu jin, 16678 Suwon-si, Gyeonggi-do (KR); Jeong, Tae Won, 16678 Suwon-si, Gyeonggi-do (KR); Lee, Jeongyub, 16678 Suwon-si, Gyeonggi-do (KR); Yang, Daejin, 16678 Suwon-si, Gyeonggi-do (KR); Shin, Keun Wook, 16678 Suwon-si, Gyeonggi-do (KR)
(74) Representative: Grünecker Patent- und Rechtsanwälte PartG mbB

(57) **Abstract**

An interconnect structure, an electronic device including the interconnect structure, and an electronic apparatus including the interconnect structure. The interconnect structure includes a dielectric layer having a trench structure; and a conductive wiring layer including an alloy represented by Chemical Formula 1 filled inside the trench structure:

Chemical Formula 1 M¹₁₋ₓM²ₓ

In Chemical Formula 1, M¹ is one of molybdenum, tungsten, or a combination thereof, M² is one of niobium, vanadium, or a combination thereof, and x is less than about 0.5.

## Description

### BACKGROUND

### 1. Field

The present disclosure relates to an interconnect structure, an electronic device including the interconnect structure, and an electronic apparatus including the interconnect structure.

### 2. Description of the Related Art

In order to provide high-density, high-performance semiconductor devices, efforts are continuing to reduce the line width or thickness of metal wiring. By reducing the line width or the thickness of metal wiring, the number of semiconductor chips integrated per wafer can be increased. Additionally, when the thickness of the metal wiring is made thinner, the capacitance of the line can be reduced, and thus the speed of the signal passing through the wiring can be increased.

However, as the line width or thickness of the metal wiring decreases, the resistance increases rapidly, and thus reducing the resistance of the metal wiring becomes more important than any other factor. Current wiring technology has a problem in that resistivity increases significantly due to grain-boundary scattering and/or surface-roughness scattering as line widths are significantly reduced.

Additionally, since deterioration may occur due to oxidation occurring at the metal/oxide interface or exposed metal surface, a technology is needed to reduce the resistance of the wiring structure while preventing metal oxidation.

### SUMMARY

An embodiment provides an interconnect structure capable of reducing or preventing an increase in resistance due to a decrease in the line width or thickness of a metal wiring.

The invention is what is claimed in the independent claims. Preferred embodiments are specified in the dependent claims.

Another embodiment provides an electronic device including the interconnect structure.

Another embodiment provides an electronic apparatus including the interconnect structure.

According to an embodiment, an interconnect structure includes a dielectric layer having a trench structure; and a conductive wiring layer filled inside the trench structure, wherein the conductive wiring layer includes an alloy represented by Chemical Formula 1:

Chemical Formula 1 M¹₁₋ₓM²ₓ

wherein, in Chemical Formula 1, M¹ is one of molybdenum (Mo), tungsten (W), or a combination thereof, M² is one of niobium, vanadium, or a combination thereof, and x is less than about 0.5.

In Chemical Formula 1, x may be less than or equal to about 0.4.

The alloy represented by Chemical Formula 1 may have a body-centered cubic (BCC) crystal structure.

The alloy represented by Chemical Formula 1 may be a solid-solution alloy.

The alloy represented by Chemical Formula 1 may have a cohesive energy of greater than or equal to about 6.0 electron volts per atom (eV/atom).

The alloy represented by Chemical Formula 1 may have a FOM (figure of merit) of less than or equal to about 5.0 x 10⁻¹⁶ ohm-meter squared (Ωm²).

The dielectric layer may include a dielectric having a dielectric constant of less than or equal to about 3.6.

The dielectric layer may include a metal oxide, a carbon-doped metal oxide, a metal carbide, a hydrogenated metal carbide, a metal nitride, a metal oxynitride, or a combination thereof.

The dielectric layer may include Al₂O₃, AIN, ZrOₓ (0<x≤2), HfOₓ (0<x≤2), SiO₂, SiCO, SiCN, SiON, SiCOH, AlSiO, BN (boron nitride), or a combination thereof.

The dielectric layer may include a Group 3A (Group 13) element, a Group 4A (Group 14) element, a Group 4B (Group 4) element, or a combination thereof.

The interconnect structure may further include a seed layer having a body-centered cubic crystal structure on a lower surface of the trench structure. The seed layer may include one of Mo, Nb, Ta, W, V, or a combination thereof, a nitride of the metal, or a combination thereof.

The seed layer may have a thickness of less than or equal to about 3 nanometers (nm).

The trench structure may have a width of less than or equal to about 10 nm and an aspect ratio of greater than or equal to about 3.

The interconnect structure may further include a barrier layer between the conductive wiring layer and the dielectric layer.

The barrier layer may include a metal, an alloy of a metal, a metal oxide, a metal nitride, or a combination thereof.

According to another embodiment, an interconnect structure includes: a dielectric layer having a trench structure; a conductive wiring layer filled inside the trench structure; and at least one of a barrier layer between the dielectric layer and the conductive wiring layer and a capping layer on the conductive wiring layer, wherein the barrier layer and the capping layer include the alloy represented by Chemical Formula 1:

Chemical Formula 1 M¹₁₋ₓM²ₓ

wherein, in Chemical Formula 1, M¹ is one of molybdenum, tungsten, or a combination thereof, M² is one of niobium, vanadium, or a combination thereof, and x is less than about 0.5.

According to another embodiment, an interconnect structure includes: a dielectric layer having a trench structure; a conductive wiring layer filled inside the trench structure; and a barrier layer between the dielectric layer and the conductive wiring layer, wherein the barrier layer includes the alloy represented by Chemical Formula 1:

Chemical Formula 1 M¹₁₋ₓM²ₓ

wherein, in Chemical Formula 1, M¹ is one of molybdenum, tungsten, or a combination thereof, M² is one of niobium, vanadium, or a combination thereof, and x is less than about 0.5.

In Chemical Formula 1, x may be less than or equal to about 0.4.

The alloy represented by Chemical Formula 1 may have a body-centered cubic (BCC) crystal structure.

The alloy represented by Chemical Formula 1 may be a solid-solution alloy.

The alloy represented by Chemical Formula 1 may have a cohesive energy of greater than or equal to about 6.0 eV/atom.

The alloy represented by Chemical Formula 1 may have a FOM (figure of merit) of less than or equal to about 5.0 x 10⁻¹⁶ Ωm².

The conductive wiring layer may include a metal, a metal alloy, or a combination thereof.

The metal may include a transition metal, a Group 3A (Group 13) metal, or a combination thereof.

The conductive wiring layer may include a metal such as copper (Cu), ruthenium (Ru), aluminum (Al), cobalt (Co), tungsten (W), molybdenum (Mo), titanium (Ti), tantalum (Ta), nickel (Ni), platinum (Pt), chromium (Cr), rhodium (Rh), iridium (Ir), palladium (Pd), or osmium (Os), an alloy thereof, or a combination thereof.

The dielectric layer may include a dielectric having a dielectric constant of less than or equal to about 3.6.

The dielectric layer may include a metal oxide, a carbon-doped metal oxide, a metal carbide, a hydrogenated metal carbide, a metal nitride, a metal oxynitride, or a combination thereof.

The dielectric layer may include Al₂O₃, AIN, ZrOₓ (0<x≤2), HfOₓ (0<x≤2), SiO₂, SiCO, SiCN, SiON, SiCOH, AlSiO, BN (boron nitride), or a combination thereof.

The dielectric layer may include a Group 3A (Group 13) element, a Group 4A (Group 14) element, a Group 4B (Group 4) element, or a combination thereof.

The barrier layer may be disposed on both sides, a lower surface, or both of the conductive wiring layer.

The barrier layer may include a first barrier layer in contact with the conductive wiring layer and a second barrier layer in contact with the dielectric layer. The first barrier layer may include the alloy of Chemical Formula 1, and the second barrier layer may include a metal selected from Mo, Nb, Ta, W, V, or a combination thereof, a nitride of the metal, or a combination thereof.

According to another embodiment, an interconnect structure includes: a dielectric layer having a trench structure; a conductive wiring layer filled inside the trench structure; and a capping layer on the conductive wiring layer, wherein the capping layer includes an alloy represented by Chemical Formula 1:

Chemical Formula 1 M¹₁₋ₓM²ₓ

wherein, in Chemical Formula 1, M¹ is one of molybdenum, tungsten, or a combination thereof, M² is one of niobium, vanadium, or a combination thereof, and x is less than about 0.5.

In Chemical Formula 1, x may be less than or equal to about 0.4.

The alloy represented by Chemical Formula 1 may have a body-centered cubic (BCC) crystal structure.

The alloy represented by Chemical Formula 1 may be a solid-solution alloy.

The conductive wiring layer may include a metal, a metal alloy, or a combination thereof.

The metal may include a transition metal, a Group 3A (Group 13) metal, or a combination thereof.

The conductive wiring layer may include a metal such as copper (Cu), ruthenium (Ru), aluminum (Al), cobalt (Co), tungsten (W), molybdenum (Mo), titanium (Ti), tantalum (Ta), nickel (Ni), platinum (Pt), chromium (Cr), rhodium (Rh), iridium (Ir), palladium (Pd), or osmium (Os), an alloy thereof, or a combination thereof.

The dielectric layer may include a dielectric having a dielectric constant of less than or equal to about 3.6.

The dielectric layer may include a metal oxide, a carbon-doped metal oxide, a metal carbide, a hydrogenated metal carbide, a metal nitride, a metal oxynitride, or a combination thereof.

The dielectric layer may include Al₂O₃, AIN, ZrOₓ (0<x≤2), HfOₓ (0<x≤2), SiO₂, SiCO, SiCN, SiON, SiCOH, AlSiO, BN (boron nitride), or a combination thereof.

The dielectric layer may include a Group 3A (Group 13) element, a Group 4A (Group 14) element, a Group 4B (Group 4) element, or a combination thereof.

The alloy represented by Chemical Formula 1 may have a cohesive energy of greater than or equal to about 6.0 eV/atom.

According to another embodiment, an interconnect structure includes: a dielectric layer having a trench structure; a conductive wiring layer filled inside the trench structure; and at least one of a barrier layer between the dielectric layer and the conductive wiring layer or a capping layer on the conductive wiring layer, wherein at least one of the conductive wiring layer, the barrier layer, or the capping layer include the alloy represented by Chemical Formula 1:

Chemical Formula 1 M¹₁₋ₓM²ₓ

wherein, in Chemical Formula 1, M¹ is one of molybdenum, tungsten, or a combination thereof, M² is one of niobium, vanadium, or a combination thereof, and x is less than about 0.5.

It will be understood that when both of the conductive wiring layer and the barrier layer, or both of the conductive wiring layer and the capping layer include the alloy represented by Chemical Formula 1, the alloy represented by Chemical Formula 1 in each layer is different from each other.

According to another embodiment, a method for manufacturing an interconnect structure includes: providing a dielectric layer having a trench structure; and forming a conductive wiring layer filled inside the trench structure; and optionally further includes: forming at least one of a barrier layer between the dielectric layer and the conductive wiring layer or a capping layer on the conductive wiring layer, wherein at least one of the conductive wiring layer, the barrier layer, or the capping layer includes the alloy represented by Chemical Formula 1. The alloy represented by Chemical Formula 1 is as described above.

Another embodiment provides an electronic device including the interconnect structure.

The electronic device may include a transistor, a capacitor, a diode, or a resistor.

Another embodiment provides an electronic device including a plurality of components, wherein the plurality of components may include a transistor, a capacitor, a diode, a resistor, or a combination thereof; and an interconnect structure disposed at a connection portion between the plurality of components or at a connection portion within each of the plurality of components. The interconnect structure is any of the interconnect structure as described above.

Another embodiment provides an electronic apparatus including the interconnect structure.

The electronic apparatus includes a plurality of units of a memory unit, an arithmetic logic unit, and a control unit.

The electronic apparatus includes a plurality of units of a memory unit, an arithmetic logic unit, and a control unit, wherein the plurality of units may each independently a plurality of components, wherein the plurality of components may include a transistor, a capacitor, a diode, a resistor, or a combination thereof; and an interconnect structure disposed at a connection portion between the plurality of components or at the connection portion within each of the plurality of components, wherein the interconnect structure includes a dielectric layer having a trench structure; and a conductive wiring layer comprising an alloy represented by Chemical Formula 1 filled inside the trench structure. The interconnect structure further comprises at least oneof a barrier layer between the dielectric layer and the conductive wiring layer and a capping layer on the conductive wiring layer, wherein at least one of the conductive wiring layer, the barrier layer, and the capping layer comprises an alloy represented by Chemical Formula 1:

Chemical Formula 1 M¹₁₋ₓM²ₓ

wherein, in Chemical Formula 1, M¹ is one of molybdenum, tungsten, or a combination thereof, M² is one of niobium, vanadium, or a combination thereof, and x is less than about 0.5.

The interconnect structure may reduce or prevent the increase in resistance by reducing or preventing the increase in resistivity due to grain-boundary scattering and/or surface-roughness scattering due to a decrease in the line width or thickness of the metal wiring, may have excellent oxidation resistance, and may increase the reliability of the device by including an alloy with high cohesive energy.

### BRIEF DESCRIPTION OF THE DRAWINGS

FIGS. 1 to 5 are cross-sectional views of interconnect structures according to embodiments.
FIGS. 6 and 7 are cross-sectional views of electronic devices according to embodiments.
FIG. 8 is a conceptual diagram showing an example of an electronic apparatus according to an embodiment.
FIGS. 9A and 9B are graphs showing the results of X-ray diffraction analysis of a stacked structure according to Example 1.
FIG. 10A is a transmission electron microscope (TEM) photograph of a cross-section of a stacked structure according to Example 2, FIG. 10B is a TEM analysis result of a MgO layer, and FIG. 10C is a drawing showing a TEM analysis result of a Mo_{0.87}Nb_{0.13} alloy layer.
FIG. 11 is a graph showing the measurement results of resistivity values according to the film thickness of the stacked structures according to Example 1, Example 2, and Comparative Example 2.
FIGS. 12A and 12B are graphs showing the results of XPS (X-ray Photoelectron Spectroscopy) analysis of the stacked structures according to Example 3 and Comparative Example 1, respectively.
FIG. 13 is a graph showing the results of SIMS (Secondary Ion Mass Spectrometry) analysis for stacked structures according to Example 3, Example 4, and Comparative Example 1.

### DETAILED DESCRIPTION

Hereinafter, example embodiments of the present disclosure will be described in detail so that a person skilled in the art would understand the same. This disclosure may, however, be embodied in many different forms and is not construed as limited to the example embodiments set forth herein.

The terminology used herein is used to describe embodiments only, and is not intended to limit the present disclosure. The singular expression includes the plural expression unless the context clearly dictates otherwise.

It will be understood that, although the terms "first," "second," "third" etc. may be used herein to describe various elements, components, regions, layers and/or sections, these elements, components, regions, layers and/or sections should not be limited by these terms. These terms are only used to distinguish one element, component, region, layer, or section from another element, component, region, layer, or section. Thus, "a first element," "component," "region," "layer," or "section" discussed below could be termed a second element, component, region, layer, or section without departing from the teachings herein. The terminology used herein is for the purpose of describing particular embodiments only and is not intended to be limiting. As used herein, the singular forms "a," "an," and "the" are intended to include the plural forms, including "at least one," unless the content clearly indicates otherwise. Thus, reference to "an" element in a claim followed by reference to "the" element is inclusive of one element and a plurality of the elements. "At least one" is not to be construed as limiting "a" or "an." "Or" means "and/or." As used herein, the term "and/or" includes any and all combinations of one or more of the associated listed items.

As used herein, terms such as "comprise," "comprise," or "have" are intended to designate the presence of implemented features, numbers, steps, components, or a combination thereof, but not one or more other features, numbers, steps, components, or a combination thereof should be understood as being excluded in advance the existence or possibility of addition.

In the drawings, the thickness of layers, films, panels, regions, etc., are exaggerated for clarity. Like reference numerals designate like elements throughout the specification. It will be understood that when an element such as a layer, film, region, or substrate is referred to as being "on" another element, it can be directly on the other element or intervening elements may also be present. In contrast, when an element is referred to as being "directly on" another element, there are no intervening elements present.

"About" as used herein is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" can mean within one or more standard deviations, or within ±5%, ±3%, or ±1% of the stated value.

Relative terms, such as "downward," "lower," or "bottom," and "upward," "upper," or "top," may be used herein to describe one element's relationship to another element as illustrated in the drawings. It will be understood that relative terms are intended to encompass different orientations of the device in addition to the orientation depicted in the Figures. For example, if the device in one of the figures is turned over, elements described as being on the "lower" side of other elements would then be oriented on "upper" sides of the other elements. The exemplary term "lower," can therefore, encompasses both an orientation of "lower" and "upper," depending on the particular orientation of the figure.

Unless otherwise defined, all terms (including technical and scientific terms) used herein have the same meaning as commonly understood by one of ordinary skill in the art to which this disclosure belongs. It will be further understood that terms, such as those defined in commonly used dictionaries, should be interpreted as having a meaning that is consistent with their meaning in the context of the relevant art and the present disclosure, and will not be interpreted in an idealized or overly formal sense unless expressly so defined herein.

Example embodiments are described herein with reference to cross section illustrations that are schematic illustrations of idealized embodiments. As such, variations from the shapes of the illustrations as a result, for example, of manufacturing techniques and/or tolerances, are to be expected. Thus, embodiments described herein should not be construed as limited to the particular shapes of regions as illustrated herein but are to include deviations in shapes that result, for example, from manufacturing. For example, a region illustrated or described as flat may, typically, have rough and/or nonlinear features. Moreover, sharp angles that are illustrated may be rounded. Thus, the regions illustrated in the figures are schematic in nature and their shapes are not intended to illustrate the precise shape of a region and are not intended to limit the scope of the present claims.

In addition, "layer" herein includes not only a shape formed on the whole surface when viewed from a plan view, but also a shape formed on a partial surface.

The use of the term "the" and similar referential terms may refer to both the singular and the plural. Unless the order of the steps constituting the method is clearly stated or stated to the contrary, these steps may be performed in any appropriate order and are not necessarily limited to the order described.

In addition, terms such as "... unit" and "module" used in the specification refer to a unit that performs at least one function or operation, which may be implemented as hardware or software, or as a combination of hardware and software.

The connections or connection members of lines between components shown in the drawings exemplify functional connections and/or physical or circuit connections, and in actual devices, may be represented as various functional connections, physical connections, or circuit connections.

As used herein, "at least one of A, B or C," "one of A, B, C, or a combination thereof" and "one of A, B, C, and a combination thereof" refer to each element and any combination (e.g., A; B; C; A and B; A and C; B and C; or A, B, and C).

Herein, "a combination thereof" means a mixture of components, a laminate, a composite, an alloy, a blend, and the like.

Herein, "metal" is interpreted as a concept that includes metals and metalloids (semimetals).

Hereinafter, an interconnect structure according to an embodiment will be described with reference to the attached drawings.

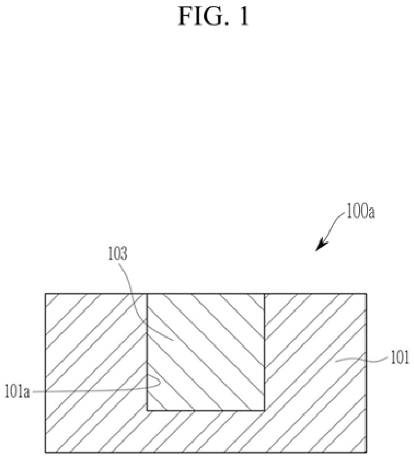

FIG. 1 is a cross-sectional view of an interconnect structure according to an embodiment.

Referring to FIG. 1, an interconnect structure 100a includes a dielectric layer 101 having a trench structure 101a; and a conductive wiring layer 103 filled inside the trench structure 101a and including an alloy represented by Chemical Formula 1:

[Chemical Formula 1] M¹₁₋ₓM²ₓ

In Chemical Formula 1, M¹ is a metal selected from Mo, W, or a combination thereof, M² is a metal selected from Nb, V, or a combination thereof, and x is less than about 0.5.

The interconnect structure 100a may be provided on a substrate (not shown) to constitute an electronic device. For example, the electronic device may include a DRAM or a logic device, and in this case, the interconnect structure 100a may be applied to a BEOL (Back End of Line) structure of the DRAM or the logic device. In addition, the interconnect structure 100a may be applied to various electronic devices.

The substrate may be a semiconductor substrate. For example, the substrate may include a Group IV semiconductor material, a Group III-V semiconductor compound, or a Group II-VI semiconductor compound. That is, the substrate may include a Group IV semiconductor material including at least one of Si, Ge, Sn, and C, a Group III-V compound semiconductor material in which at least one of B, Ga, In, and Al is combined with at least one of N, P, As, and Sb, or a Group II-VI compound semiconductor material in which at least one of Be, Mg, Cd, and Zn is combined with at least one of O, S, Se, and Te. As examples, the substrate may include Si, Ge, SiC, SiGe, SiGeC, Ge alloy, GaAs, InAs, InP, and the like. However, this is an example, and various other semiconductor materials can be used as substrates.

The substrate may include, for example, a Silicon-On-Insulator (SOI) substrate or a Silicon Germanium-On-Insulator (SGOI) substrate. Additionally, the substrate may include a non-doped semiconductor material or a doped semiconductor material.

The substrate may include at least one semiconductor device (not shown). The semiconductor device may include, for example, at least one of a transistor, a capacitor, a diode, and a resistor. However, the present disclosure is not limited thereto.

The dielectric layer 101 is formed on the substrate. This dielectric layer 101 may have a single-layer structure or a multi-layer structure in which a plurality of layers including different materials are stacked. The dielectric layer 101 may be an intermetallic dielectric (IMD) layer. The dielectric layer 101 may include, for example, a low-dielectric constant (low-k) dielectric material. For example, the dielectric layer 101 may include a dielectric having a dielectric constant of less than or equal to about 3.6, for example less than or equal to about 3.5, less than or equal to about 3.3, less than or equal to about 3.0, less than or equal to about 2.8, or less than or equal to about 2.7, and greater than or equal to about 0.01, for example greater than or equal to about 0.02, greater than or equal to about 0.03, greater than or equal to about 0.04, or greater than or equal to about 0.05. Here, the low-k material can mean a material with a lower dielectric constant (k) than silicon oxide (SiO₂). As the size of the device decreases, the spacing between conductive wiring layers 103 may decrease. Accordingly, the size of the dielectric layer 101 area disposed between the conductive wiring layers 103 is reduced, which may cause crosstalk that affects the performance of the device. By using a low-k material in the dielectric layer 101, parasitic capacitance affecting the performance of the device can be reduced, and also fast switching speed and low heat dissipation can be achieved.

In an embodiment, the dielectric layer 101 may include a metal oxide, a carbon-doped metal oxide, a metal carbide, a hydrogenated metal carbide, a metal nitride, a metal oxynitride, or a combination thereof. The dielectric layer 101 may include Al₂O₃, AIN, ZrOₓ (0<x≤2), HfOₓ (0<x≤2), SiO₂, SiCO, SiCN, SiON, SiCOH, AlSiO, BN (boron nitride) or a combination thereof. It will be understood that "SiCO, SiCN, SiON, SiCOH, AlSiO" only indicate the kinds of elements contained in each material, but do not indicate the ratio of each element.

The dielectric layer 101 may include a Group 3A (Group 13) element, a Group 4A (Group 14) element, a Group 4B (Group 4) element, or a combination thereof.

The dielectric layer 101 can be formed on a substrate through a deposition process used in a general semiconductor manufacturing process, such as chemical vapor deposition (CVD), plasma enhanced CVD (PECVD), or spin coating.

The dielectric layer 101 may have a single-layer structure or a multi-layer structure in which multiple layers including dielectrics are stacked.

The trench structure 101a may be formed in the dielectric layer 101 to a predetermined depth. Such a trench structure 101a may be formed, for example, through a photolithography process and an etching process. The trench structure 101a may have a line width of less than or equal to about 10 nm, for example, less than or equal to about 9 nm, less than or equal to about 8 nm, less than or equal to about 7 nm, or less than or equal to about 6 nm and greater than or equal to about 1 nm, and an aspect ratio of greater than or equal to about 3, for example, greater than or equal to about 4, greater than or equal to about 5, or greater than or equal to about 6. The aspect ratio means the depth of the trench structure 101a divided by the width thereof.

The conductive wiring layer 103 including the alloy represented by Chemical Formula 1 is present inside the trench structure 101a of the dielectric layer 101. The conductive wiring layer 103 forms the wiring structure of the device and may be provided to fill the internal portion of the trench structure 101a.

In Chemical Formula 1, M¹ is a main component forming the alloy and M² is an auxiliary component. By adjusting the x value in Chemical Formula 1 to less than about 0.5, even if the line width of the conductive wiring layer 103 is reduced, the resistance value of the interconnect structure 100a may be prevented from rapidly increasing. The value of x in Chemical Formula 1 may be in a range of less than or equal to about 0.4, less than or equal to about 0.35, less than or equal to about 0.3, less than or equal to about 0.25, less than or equal to about 0.2, less than or equal to about 0.18, or less than or equal to about 0.16, and may be in a range of greater than or equal to about 0.01, greater than or equal to about 0.03, or greater than or equal to about 0.05, or greater than or equal to about 0.07. For example, the value of x in Chemical Formula 1 may be in the range of about 0.01 to about 0.4. Within the above range, an increase in resistance due to the decrease in the line width of the conductive wiring layer 103 may be alleviated or prevented, and a cohesive energy of the alloy may be increased to improve an adhesive strength with adjacent layers.

The alloy represented by Chemical Formula 1 may have a cohesive energy of greater than or equal to about 6.0 electronVolts per atom (eV/atom), for example, greater than or equal to about 6.5 eV/atom, and less than or equal to about 10 eV/atom. The cohesive energy may be obtained by an ab initio calculation method based on DFT (density functional theory). When the cohesive energy is within the above range, there is no need for a separate barrier layer to prevent diffusion of the material of the conductive wiring layer 103 or a liner layer to improve the adhesive strength of the conductive wiring layer 103. The liner layer or barrier layer may be a factor that increases the resistance. Thus, in this way, not forming these layers may reduce or prevent the increase in resistance of the interconnect structure.

The alloy included in the conductive wiring layer 103 may have a single crystal structure and may have a body-centered cubic (BCC) crystal structure. In this case, the oxidation resistance of the alloy increases, thereby preventing oxidation of the conductive wiring layer 103.

The alloy represented by Chemical Formula 1 may be a solid-solution alloy. When it exists as a solid-solution alloy, the resistivity may be easily controlled according to the alloy composition compared to an intermetallic compound.

The alloy represented by Chemical Formula 1 may have a FOM (figure of merit) of less than or equal to about 5.0 x 10⁻¹⁶ ohm-meter squared (Ωm²), for example, less than or equal to about 4.9 x 10⁻¹⁶ Ωm², or less than or equal to about 4.8 x 10⁻¹⁶ Ωm². The alloy represented by Chemical Formula 1 may have an FOM of greater than or equal to about 1.0 x 10⁻¹⁶ Ωm². The FOM may be obtained by an ab initio calculation method based on DFT (density functional theory). Within the above range, the increase in resistance due to a decrease in the line width of the conductive wiring layer 103 may be alleviated.

The conductive wiring layer 103 may be formed using the precursor material of M¹ and the precursor material of M² through chemical vapor deposition (CVD), plasma enhanced chemical vapor deposition (PECVD), physical vapor deposition (PVD), electroplating, chemical solution deposition, or electroless plating.

In order to achieve high integration of semiconductor devices, the size of semiconductor devices is gradually decreasing, and accordingly, the line width or thickness of conductive wiring is also decreasing. As the line width or thickness of the conductive wiring decreases, there is a problem that the resistivity increases significantly due to grain-boundary scattering and/or surface-roughness scattering. This increase in resistivity may lead to an increase in resistance, and thereby cause defects in the conductive wiring by causing electromigration, which may damage the conductive wiring layer 103. Here, electromigration refers to the movement of matter (e.g., metal atom) resulting from the transfer of momentum between conducting/flowing electrons and atomic nuclei within the metal. The conductive wiring layer 103 may prevent or reduce an increase in resistance due to a decrease in line width and reduce or prevent defects due to electromigration caused by an increase in resistance by including the alloy of Chemical Formula 1 having a specific composition.

The interconnect structure 100a may further include a seed layer having a body-centered cubic crystal structure (BCC) on the lower surface of the trench structure 101a.

Since an alloy having a BCC crystal structure may be easily formed on a seed layer having the BCC crystal structure, the seed layer and the conductive wiring layer may have a lattice mismatch of less than or equal to about 5%.

The seed layer may have a thickness of less than or equal to about 3 nm, for example, less than or equal to about 2.5 nm, less than or equal to about 2.0 nm, less than or equal to about 1.5 nm, or less than or equal to about 1.0 nm, and greater than or equal to about 0.01 nm, for example, greater than or equal to about 0.02 nm, greater than or equal to about 0.03 nm, greater than or equal to about 0.04 nm, or greater than or equal to about 0.05 nm. Within the above range, the crystal structure of the alloy of the conductive wiring layer 103 may be helped to grow into a single crystal structure, and an increase in resistance due to a decrease in line width may be prevented or reduced.

The seed layer may include a metal selected from Mo, Nb, Ta, W, V, or a combination thereof, a nitride of the metal, or a combination thereof.

The seed layer may be formed using a precursor material of the metal through chemical vapor deposition (CVD), plasma enhanced chemical vapor deposition (PECVD), physical vapor deposition (PVD), electroplating, chemical solution deposition, or electroless plating.

In the interconnect structure 100a, since the conductive wiring layer 103 includes an alloy of a specific composition with excellent cohesive energy, there is no need for a separate barrier layer to prevent diffusion of the material of the conductive wiring layer 103 or a liner layer to improve the adhesive strength of the conductive wiring layer 103.

However, if necessary, a barrier layer may be further included between the dielectric layer 101 and the conductive wiring layer 103. In the interconnect structure, the barrier layer may be disposed on both sides, a lower surface, or both of the trench structure 101a of the dielectric layer 101.

The barrier layer may include a metal, an alloy of a metal, a metal oxide, a metal nitride, or a combination thereof.

The barrier layer may prevent the material of the conductive wiring layer 103 from diffusing into the dielectric layer 101. The barrier layer may have a multi-layer structure in which a plurality of layers including different materials are stacked. For example, the barrier layer may include a first barrier layer in contact with the conductive wiring layer 103 and a second barrier layer in contact with the dielectric layer 101, and the first barrier layer may include a metal or an alloy of metals and the second barrier layer may include a metal nitride or a metal oxide.

The metal that can be used in the barrier layer may be selected from magnesium (Mg), aluminum (Al), scandium (Sc), titanium (Ti), vanadium (V), chromium (Cr), manganese (Mn), nickel (Ni), zinc (Zn), gallium (Ga), zirconium (Zr), niobium (Nb), molybdenum (Mo), lead (Pd), silver (Ag), cadmium (Cd), indium (In), tin (Sn), lanthanum (La), hafnium (Hf), tantalum (Ta), tungsten (W), iridium (Ir), platinum (Pt), gold (Au), bismuth (Bi), nickel (Ni), ruthenium (Ru), and a combination thereof. The metal alloy of the barrier layer may include RuTa, IrTa, and the like.

The metal oxide of the barrier layer may include a compound represented by Chemical Formula 2.

[Chemical Formula 2] MₐO_{b}

In Chemical Formula 2,
M may be at least one selected from Mn, Al, Ti, Zr, Hf, Mg, Si, Ge, Y, Lu, La, Ta, and Sr, 0 < a ≤ 2, and 0 < b ≤ 3.

Examples of the metal oxide may include MnO, AlO_{z} (0<z≤3/2), TaO_{z} (0< z ≤5/2), TiO₂, ZrO₂, HfO₂, MgO, SiO₂, GeO₂, Y₂O₃, Lu₂O₃, La₂O₃, SrO, and the like.

The metal nitride of the barrier layer may include tantalum nitride (TaN), titanium nitride (TiN), ruthenium nitride (RuN), tungsten nitride (WN), aluminum nitride (AIN), IrTaN, TiSiN, and the like.

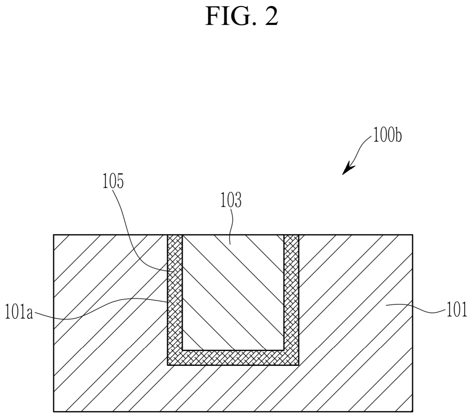

Referring to FIG. 2, an interconnect structure according to another embodiment is described.

FIG. 2 is a cross-sectional view of an interconnect structure 100b according to another embodiment.

Referring to FIG. 2, an interconnect structure 100b includes a dielectric layer 101 having a trench structure 101a; a conductive wiring layer 103 filled within the trench structure 101a; and a barrier layer 105 between the dielectric layer 101 and the conductive wiring layer 103, wherein the barrier layer 105 includes an alloy represented by Chemical Formula 1.

[Chemical Formula 1] M¹₁₋ₓM²ₓ

In Chemical Formula 1, M¹ is a metal selected from Mo, W, or a combination thereof, M² is a metal selected from Nb, V, or a combination thereof, and x is less than about 0.5.

The dielectric layer 101 having the trench structure 101a of the interconnect structure 100b is the same as that of the interconnect structure 100a illustrated in FIG. 1, so a duplicate description is omitted.

The conductive wiring layer 103 filled inside the trench structure 101a may include a metal, a metal alloy, or a combination thereof.

The metal may include a transition metal, a Group 3A (Group 13) metal, or a combination thereof.

The conductive wiring layer 103 may include a metal selected from copper (Cu), ruthenium (Ru), aluminum (Al), cobalt (Co), tungsten (W), molybdenum (Mo), titanium (Ti), tantalum (Ta), nickel (Ni), platinum (Pt), chromium (Cr), rhodium (Rh), iridium (Ir), palladium (Pd), or osmium (Os), an alloy thereof, or a combination thereof.

The barrier layer 105 may be disposed on both sides, a lower surface, or both of the conductive wiring layer 103. Due to inclusion of the alloy represented by Chemical Formula 1, the barrier layer 105 may reduce the resistance of the conductive wiring layer 103 and prevent electrical deterioration of the conductive wiring layer 103.

The barrier layer 105 includes the alloy represented by Chemical Formula 1.

In Chemical Formula 1, M¹ is a main component forming the alloy and M² is an auxiliary component. By adjusting the x value in Chemical Formula 1 to less than about 0.5, even if the line width of the conductive wiring layer 103 is reduced, the resistance value of the interconnect structure 100b may be prevented from rapidly increasing. The value of x in Chemical Formula 1 may be in a range of less than or equal to about 0.4, less than or equal to about 0.35, less than or equal to about 0.3, less than or equal to about 0.25, less than or equal to about 0.2, less than or equal to about 0.18, or less than or equal to about 0.16, and may be in a range of greater than or equal to about 0.01, greater than or equal to about 0.03, or greater than or equal to about 0.05, or greater than or equal to about 0.07. For example, the value of x in Chemical Formula 1 may be in the range of about 0.01 to about 0.4. Within the above range, an increase in resistance due to the decrease in the line width of the conductive wiring layer 103 may be alleviated or prevented by reducing or preventing electron grain-boundary scattering and/or surface-roughness scattering, and a cohesive energy of the alloy may be increased to improve an adhesive strength with adjacent layers.

The alloy represented by Chemical Formula 1 may have a cohesive energy of greater than or equal to about 6.0 eV/atom, for example, greater than or equal to about 6.5 eV/atom, and less than or equal to about 10 eV/atom. The cohesive energy may be obtained by an ab initio calculation method based on DFT (density functional theory). Within the above range, the performance of the barrier layer 105 may be further improved.

The alloy included in the barrier layer 105 may have a single crystal structure and may have a body-centered cubic (BCC) crystal structure. In this case, the oxidation resistance of the alloy increases, thereby preventing oxidation of the adjacent conductive wiring layer 103.

The alloy represented by Chemical Formula 1 may be a solid-solution alloy. When it exists as a solid-solution alloy, the resistivity can be easily controlled according to the alloy composition compared to an intermetallic compound.

The alloy represented by Chemical Formula 1 may have a FOM (figure of merit) of less than or equal to about 5.0 x 10⁻¹⁶ Ωm², for example, less than or equal to about 4.9 x 10⁻¹⁶ Ωm², or less than or equal to about 4.8 x 10⁻¹⁶ Ωm². The alloy represented by Chemical Formula 1 may have an FOM of greater than or equal to about 1.0 x 10⁻¹⁶ Ωm². The FOM may be obtained by an ab initio calculation method based on DFT (density functional theory). Within the above range, the increase in resistance due to a decrease in the line width of the conductive wiring layer 103 may be alleviated.

The barrier layer 105 may have a single-layer structure or a multi-layer structure in which a plurality of layers including different materials are stacked. For example, the barrier layer may include a first barrier layer in contact with the conductive wiring layer 103 and a second barrier layer in contact with the dielectric layer 101. The first barrier layer may include the alloy of Chemical Formula 1, and the second barrier layer may include a metal selected from Mo, Nb, Ta, W, V, or a combination thereof, a nitride of the metal, or a combination thereof. The second barrier layer may help the crystal structure of the alloy of the first barrier layer grow into a single crystal structure (e.g., a BCC structure).

The barrier layer 105 may be formed using the precursor material of M¹ and the precursor material of M² through chemical vapor deposition (CVD), plasma enhanced chemical vapor deposition (PECVD), physical vapor deposition (PVD), electroplating, chemical solution deposition, or electroless plating.

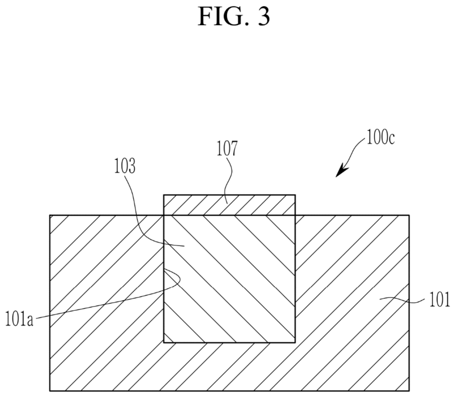

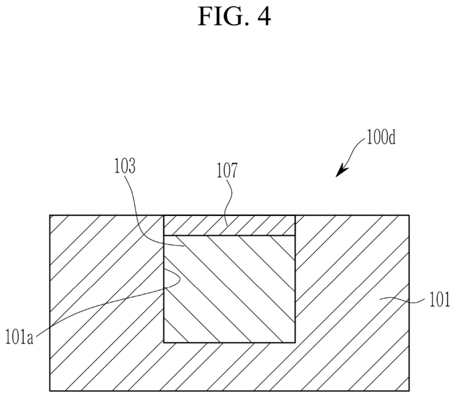

Referring to FIGS. 3 and 4, interconnect structures according to another embodiment are described.

FIGS. 3 and 4 are cross-sectional views of interconnect structures 100c and 100d according to another embodiment. Referring to FIGS. 3 and 4, the interconnect structures 100c and 100d includes a dielectric layer 101 having a trench structure 101a; a conductive wiring layer 103 filled within the trench structure 101a; and a capping layer 107 on the conductive wiring layer 103, wherein the capping layer 107 includes the alloy represented by Chemical Formula 1.

[Chemical Formula 1] M¹₁₋ₓM²ₓ

In Chemical Formula 1, M¹ is a metal selected from Mo, W, or a combination thereof, M² is a metal selected from Nb, V, or a combination thereof, and x is less than about 0.5.

The dielectric layer 101 having the trench structure 101a of the interconnect structures 100c and 100d is identical to that of the interconnect structure 100a illustrated in FIG. 1, so a duplicate description is omitted.

The conductive wiring layer 103 filled inside the trench structure 101a may include a metal, a metal alloy, or a combination thereof.

The metal may include a transition metal, a Group 3A (Group 13) metal, or a combination thereof.

The conductive wiring layer 103 may include a metal selected from copper (Cu), ruthenium (Ru), aluminum (Al), cobalt (Co), tungsten (W), molybdenum (Mo), titanium (Ti), tantalum (Ta), nickel (Ni), platinum (Pt), chromium (Cr), rhodium (Rh), iridium (Ir), palladium (Pd), or osmium (Os), an alloy thereof, or a combination thereof.

The capping layer 107 is formed on the upper surface of the conductive wiring layer 103 and includes the alloy represented by Chemical Formula 1. Additionally, as illustrated in FIG. 3, the capping layer 107 may be disposed to cover the upper surface of the conductive wiring layer 103 and a portion of the upper surface of the dielectric layer 101. Additionally, as illustrated in FIG. 4, the capping layer 107 may be disposed in the internal portion of the trench structure 101a. This capping layer 107 may reduce the resistance of the conductive wiring layer 103 and prevent electrical deterioration of the conductive wiring layer 103 by reducing or preventing surface scattering and grain boundary scattering of electrons.

In Chemical Formula 1, M¹ is a main component forming the alloy and M² is an auxiliary component. By adjusting the x value in Chemical Formula 1 to less than about 0.5, even if the line width of the conductive wiring layer 103 is reduced, the resistance value of the interconnect structures 100c and 100d may be prevented from rapidly increasing. The value of x in Chemical Formula 1 may be in a range of less than or equal to about 0.4, less than or equal to about 0.35, less than or equal to about 0.3, less than or equal to about 0.25, less than or equal to about 0.2, less than or equal to about 0.18, or less than or equal to about 0.16, and may be in a range of greater than or equal to about 0.01, greater than or equal to about 0.03, or greater than or equal to about 0.05, or greater than or equal to about 0.07. For example, the value of x in Chemical Formula 1 may be in the range of about 0.01 to about 0.4. Within the above range, an increase in resistance due to the decrease in the line width of the conductive wiring layer 103 may be alleviated or prevented, and a cohesive energy of the alloy may be increased to improve an adhesive strength with adjacent layers.

The alloy represented by Chemical Formula 1 may have a cohesive energy of greater than or equal to about 6.0 eV/atom, for example, greater than or equal to about 6.5 eV/atom, and less than or equal to about 10 eV/atom. The cohesive energy may be obtained by an ab initio calculation method based on DFT (density functional theory). Within the above range, the performance of the capping layer 107 may be further improved.

The alloy included in the capping layer 107 may have a single crystal structure and may have a body-centered cubic (BCC) crystal structure. In this case, the oxidation resistance of the alloy increases, thereby preventing oxidation of the adjacent conductive wiring layer 103.

The alloy represented by Chemical Formula 1 may be a solid-solution alloy. When it exists as a solid-solution alloy, the resistivity can be easily controlled according to the alloy composition compared to an intermetallic compound.

The alloy represented by Chemical Formula 1 may have a FOM (figure of merit) of less than or equal to about 5.0 x 10⁻¹⁶ Ωm², for example, less than or equal to about 4.9 x 10⁻¹⁶ Ωm², or less than or equal to about 4.8 x 10⁻¹⁶ Ωm². The alloy represented by Chemical Formula 1 may have an FOM of greater than or equal to about 1.0 x 10⁻¹⁶ Ωm². The FOM may be obtained by an ab initio calculation method based on DFT (density functional theory). Within the above range, the increase in resistance due to a decrease in the line width of the conductive wiring layer 103 may be alleviated.

The capping layer 107 may have a single-layer structure or a multi-layer structure in which a plurality of layers including different materials are stacked.

A thickness of the capping layer 107 may be in the range of about 1 nm to about 20 nm, about 1 nm to about 10 nm, about 1 nm to about 5 nm, or about 1 nm to about 3 nm.

The capping layer 107 may be formed using the precursor material of M¹ and the precursor material of M² through chemical vapor deposition (CVD), plasma enhanced chemical vapor deposition (PECVD), physical vapor deposition (PVD), electroplating, chemical solution deposition, or electroless plating.

Before forming the capping layer 107, the upper surface of the conductive wiring layer 103 may be planarized. Here, the planarization process may include, but is not limited to, a chemical mechanical polishing (CMP) process or a grinding process, for example.

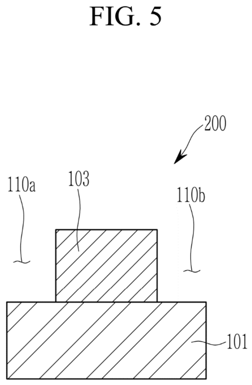

If the upper surface is a flat surface, the wiring structure including the conductive wiring layer and optionally the barrier layer and capping layer may have empty spaces on both sides. This structure is illustrated in FIG. 5.

FIG. 5 is a cross-sectional view of an interconnect structure according to another embodiment.

Referring to FIG. 5, the interconnect structure 200 includes a conductive wiring layer 103 stacked on a dielectric layer 101 and empty spaces 110a and 110b exist on both sides of the conductive wiring layer 103. The conductive wiring layer 103 includes an alloy of Chemical Formula 1. The alloy of Chemical Formula 1 is as described above. The detailed description of the dielectric layer 101 may refer to the description about FIG. 1.

In FIG. 5, the empty spaces 110a and 110b may be filled with air, etc., and if the empty spaces 110a and 110b are an air gap filled with air, the air gap itself can act as a dielectric. In this case, the structure consisted of the empty spaces 110a and 110b (e.g., air gap) and the dielectric layer 101 may correspond to the dielectric layer 101 having a trench structure in FIGS. 1 to 4. Thus, it will be understood that the term "a dielectric layer having a trench structure" used herein encompasses not only a dielectric layer of a solid material having a trench structure (e.g., as shown in FIGS. 1 to 4), but also a structure consisted of a dielectric layer of a solid material which does not have a trench structure (e.g., which is flat) and empty spaces (e.g., air gap) at both ends on the upper surface of the dielectric layer (e.g., as shown in FIG. 5).

In FIG. 5, a structure in which a dielectric layer 101 and a conductive wiring layer 103 are stacked is illustrated, but the dielectric layer and the conductive wiring layer may be stacked, and a barrier layer may be further disposed on at least one of both sides and the lower surface of the conductive wiring layer, and the barrier layer may include the alloy of Chemical Formula 1. Additionally, it may be a stacked structure in which a dielectric layer, a conductive wiring layer, and a capping layer are sequentially stacked, and the capping layer may include the alloy of Chemical Formula 1. The alloy of Chemical Formula 1 is as described above.

The interconnect structure 200 can alleviate or prevent an increase in electrical resistance due to a decrease in the line width of a wiring due to high integration of semiconductor devices and reduce or prevent defects due to electromigration caused by an increase in electrical resistance within the interconnect structure.

As described above, by including an alloy having a composition of Chemical Formula 1 in at least one of the conductive wiring layer 103, the barrier layer 105 and/or the capping layer 107, an increase in electrical resistance due to a decrease in the wiring line width can be prevented, and defects in the wiring due to electromigration may be reduced or prevented.

According to another embodiment, a method for manufacturing an interconnect structure includes: providing a dielectric layer having a trench structure; and forming a conductive wiring layer filled inside the trench structure; and optionally further includes: forming at least one of a barrier layer between the dielectric layer and the conductive wiring layer or a capping layer on the conductive wiring layer, wherein at least one of the conductive wiring layer, the barrier layer, or the capping layer includes the alloy represented by Chemical Formula 1. The description of the dielectric layer, conductive wiring layer, barrier layer, and capping layer and the method of forming them are as described above.

According to another embodiment, an electronic device includes: a plurality of components, wherein the plurality of components may include at least one of a transistor, a capacitor, a diode, or a resistor, and the interconnect structure is disposed at a connection portion between the plurality of components or at a connection portion within each component.

The aforementioned interconnect structures 100a, 100b, 100c, 100d, and 200 may constitute electronic devices. For example, the electronic device may include a semiconductor device, in which case the interconnect structures 100a, 100b, 100c, 100d, and 200 may be applied to a BEOL (Back End of Line) structure of the semiconductor device, and the like. The semiconductor device may include at least one of a transistor, a capacitor, a diode, or a resistor. For example, the transistor may have various structures, including a FinFET, a GAAFET, an MBCFET, a CFET, or a VFET, but is not limited thereto. For example, the transistor may include a two-dimensional material as the active material and may be a complementary field effect transistor (C-FET), a multi bridge channel field effect transistor (MBC-FET), or a carbon nanotube field effect transistor (CNT-FET), but is not limited thereto. In addition, the interconnect structures 100a, 100b, 100c, 100d, and 200 may be applied to various electronic devices.

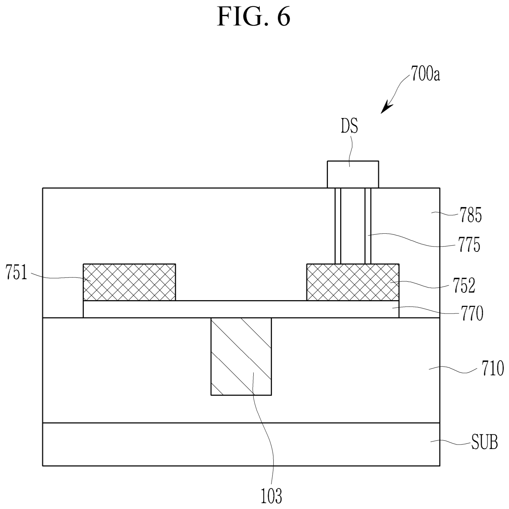

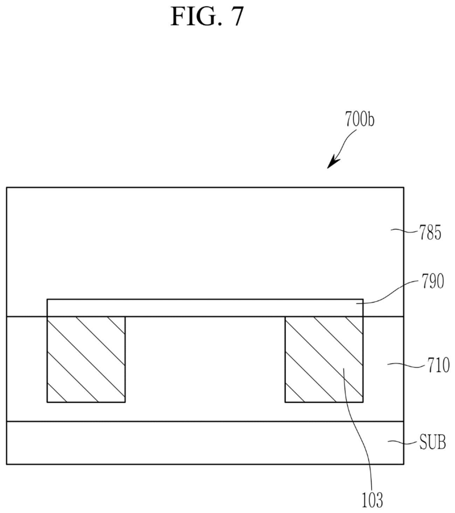

Hereinafter, an electronic device including the aforementioned interconnect structures will be described with reference to FIGS. 6 and 7.

FIGS. 6 and 7 are cross-sectional views of electronic devices according to some embodiments.

Referring to FIG. 6, in an embodiment, the electronic device 700a may be formed of a transistor connected to a data storage DS. The electronic device 700a may include a substrate SUB, an oxide dielectric layer 710, and a conductive wiring layer 103 present within a trench of the oxide dielectric layer 710. The conductive wiring layer 103 may have the same structure as that shown in FIG. 1. In FIG. 6, the interconnect structure 100a may be replaced with any of the structures illustrated in FIGS. 2 to 5.

The gate insulating layer 770 is formed on the oxide dielectric layer 710. The source electrode 751 and the drain electrode 752 are arranged spaced apart from each other on the gate insulating layer 770. The conductive wiring layer 103 may be configured to operate as a gate electrode of an electronic device 770a.

The electronic device 700a may further include an insulating layer 785, such as including silicon oxide, covering the source electrode 751, the gate insulating layer 770, and the drain electrode 752, and a data storage DS (e.g., a capacitor) may be on the insulating layer 785. Contact 775 including an electrically conductive material such as a metal or a metal alloy may connect data storage DS and drain electrode 752.

Referring to FIG. 7, in an embodiment, the electronic device 700b different from the electronic device 700a shown in FIG. 6 in that the gate insulating layer 770, the contact 775, the source electrode 751, the drain electrode 752, and the data storage DS are omitted. Additionally, the oxide dielectric layer 710 includes two trenches spaced apart from each other, and each of the trenches is formed in the same structure as the interconnect structure in FIG. 1. That is, each of the trenches may include a conductive wiring layer 103 formed therein.

The upper conductive layer 790 is formed on the oxide dielectric layer 710 and contacts the upper surface of the conductive wiring layer 103 in each interconnect structure, so that the interconnect structures can be electrically connected to each other. The upper conductive layer 790 may include a conductive material such as a metal, a metal alloy, or a doped semiconductor. In FIG. 7, the interconnect structure 100a may be replaced with any one of the interconnect structures illustrated in FIGS. 2 to 5.

The aforementioned interconnect structures may be included in various electronic apparatuses.

The electronic apparatus includes: a plurality of units of a memory unit, an arithmetic logic unit, and a control unit, the plurality of units each independently including a plurality of components, the plurality of components including a transistor, a capacitor, a diode, a resistor, or a combination thereof, and an interconnect structure disposed at a connection portion between the plurality of components or at a connection portion within each component.

The electronic apparatuses may include mobile devices, computers, laptops, tablet PCs, smart watches, sensors, digital cameras, e-books, network devices, vehicle navigation systems, Internet of Things (IoT) devices, Internet of Everything (IoE) devices, drones, door locks, safes, automated teller machines (ATMs), security devices, medical devices, or automotive electrical components, but are not limited thereto.

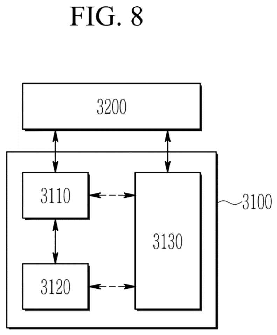

FIG. 8 is a conceptual diagram showing an example of an electronic apparatus according to an embodiment.

Referring to FIG. 8, an electronic apparatus 3100 according to an embodiment may include a memory unit 3110, an arithmetic logic unit 3120, and a control unit 3130, which may be electrically connected. For example, the memory unit 3110, the arithmetic logic unit 3120, and the control unit 3130 may be implemented as a single integrated circuit device (semiconductor chip), and may be monolithically integrated on a single substrate to be implemented as a single integrated circuit device (semiconductor chip). The memory unit 3110, the arithmetic logic unit 3120, and the control unit 3130 may each independently include a transistor, a capacitor, a diode, a resistor, or a combination thereof. The electronic apparatus 3100 may be connected to one or more input/output devices 3200.

Hereinafter, the embodiments are illustrated in more detail with reference to examples. However, the following examples are for illustrative purposes only and do not limit the scope of the rights.

### Example 1: Manufacturing of Stacked Structure

A stacked structure with a Mo_{0.926}Nb_{0.074} alloy layer is manufactured by sputtering Mo and Nb simultaneously onto on a 0.5 mm-thick MgO (100) substrate (Manufactured by DASOM RMS, MgO single crystal substrate exposing the (100) crystal plane) at 250 °C, supplying the elements in a molar ratio to achieve a Mo_{0.926}Nb_{0.074} alloy composition.

### Example 2: Manufacturing of Stacked Structure

A stacked structure with a Mo_{0.87}Nb_{0.13} alloy layer is manufactured by sputtering Mo and Nb simultaneously onto a 0.5 mm-thick MgO (100) substrate at 250 °C, supplying the elements in a molar ratio to achieve a Mo_{0.87}Nb_{0.13} alloy composition.

### Example 3: Manufacturing of Stacked Structure

A stacked structure with a Mo_{0.85}Nb_{0.15} alloy layer is manufactured by sputtering Mo and Nb simultaneously onto a 0.5 mm-thick MgO (100) substrate at 250 °C, supplying the elements in a molar ratio to achieve a Mo_{0.85}Nb_{0.15} alloy composition.

### Example 4: Manufacturing of Stacked Structure

A stacked structure with a Mo_{0.85}Nb_{0.15} layer is manufactured by sputtering Mo and Nb simultaneously onto a SiO₂/Si (100 nm/0.725 mm) dielectric layer at 250 °C, supplying the elements in a molar ratio to achieve a Mo_{0.85}Nb_{0.15} alloy composition.

### Comparative Example 1: Manufacturing of Stacked Structure

A stacked structure is manufactured by depositing Mo into a metal layer on a 0.5 mm-thick MgO (100) substrate at 250 °C in the sputtering method.

### Comparative Example 2: Manufacturing of Stacked Structure

A Cu/TaN (imec, IITC2019) film is prepared.

### Evaluation 1: Crystal Structure of Stacked Structure

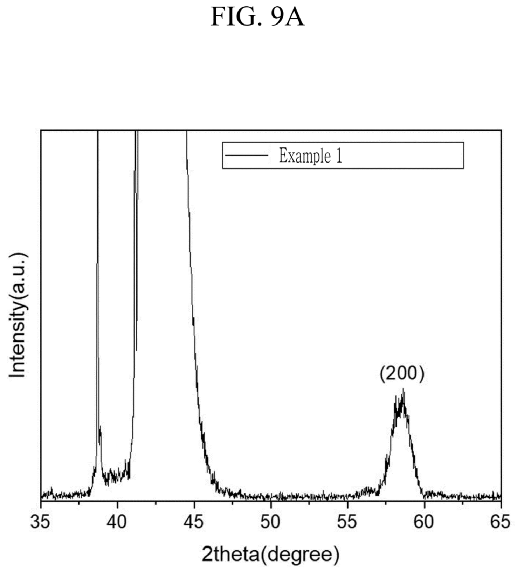

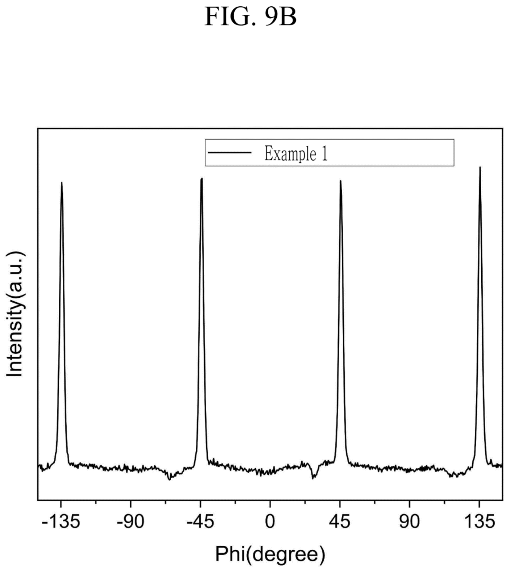

The stacked structure having a film thickness of 6.7 nm according to Example 1 is subjected to X-ray diffraction analysis (2θ scan, light source: Cu Kα, 2θ = 35 ° to 65 °, analysis device: XRD_General (manufacturer: Bruker)), and the results are shown in FIG. 9A. The stacked structure having a film thickness of 6.7 nm according to Example 1 is subjected to X-ray diffraction analysis (phi-scan, high temperature HR-XRD (manufacturer: Malvern Panalytical), and the results are shown in FIG. 9B. FIGS. 9A and 9B are graphs showing the X-ray diffraction analysis result of the stacked structure according to Example 1. Referring to FIGS. 9A and 9B, the stacked structure of Example 1 is confirmed that the Mo_{0.926}Nb_{0.074} alloy have a body-centered cubic (BCC) crystal structure. The fact that the Mo_{0.926}Nb_{0.074} alloy has a body-centered cubic crystal structure, like Mo, demonstrates that the alloy of Example 1 is a solid-solution alloy.

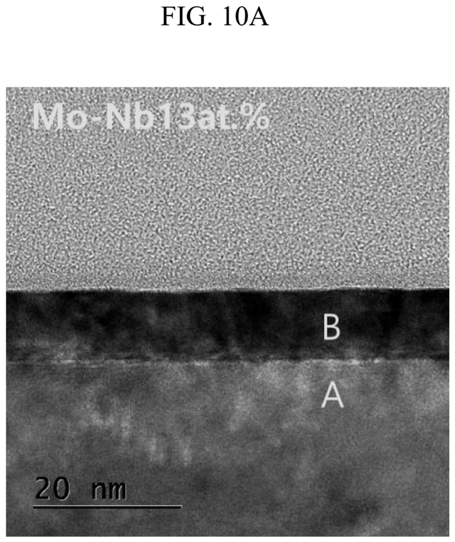

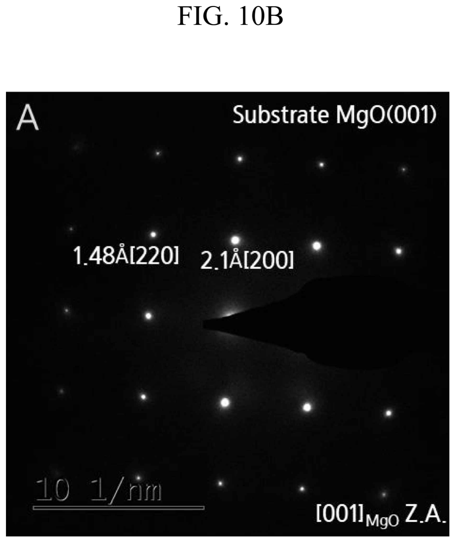

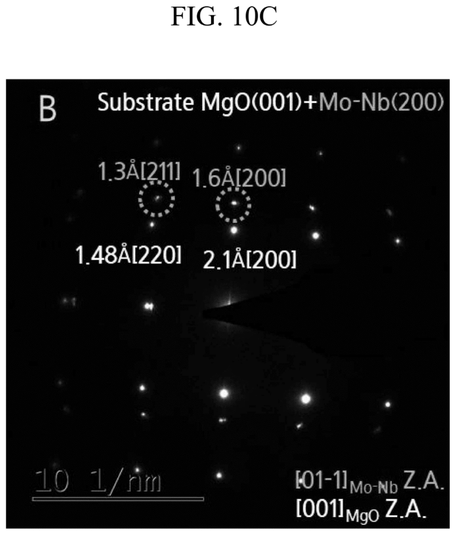

The stacked structure having a film thickness of 9.7 nm according to Example 2 is subjected to a transmission electron microscope (TEM) analysis, and the results are shown in FIGS. 10A to 10C. FIG. 10A shows a cross-sectional TEM image of the stacked structure according to Example 2, FIG. 10B shows the TEM analysis result of the MgO layer (the A layer of FIG. 10A), and FIG. 10C shows the TEM analysis result of the Mo_{0.87}Nb_{0.13} alloy layer (the B layer of FIG. 10A). Referring to FIGS. 10A to 10C, the Mo_{0.87}Nb_{0.13} alloy layer is confirmed to have a single crystal structure.

### Evaluation 2: Resistivity Measurement According to Thickness of Stacked Structure

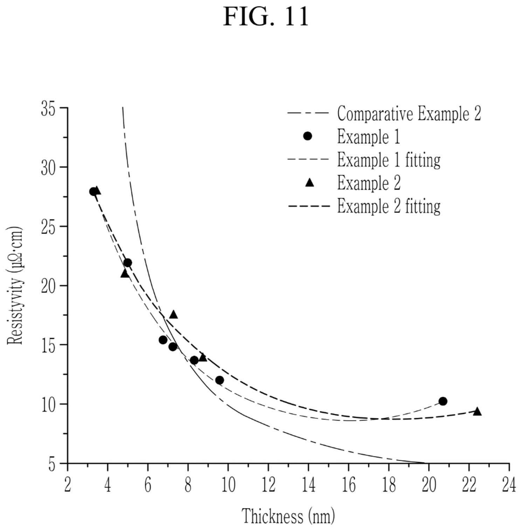

The stacked structures of Examples 1 and 2 and Comparative Example 2 are measured with respect to resistivity according to a film thickness in a 4-point probe method, and the results are shown in FIG. 11. FIG. 11 is a graph showing the results of resistivity measurements according to a film thickness of the stacked structures of Examples 1 and 2 and Comparative Example 2. In order to check resistivity changes according to a film thickness of the stacked structures according to Examples 1 and 2, the corrected (fitted) values are also shown. Referring to FIG. 11, the stacked structures of Examples 1 and 2, compared to that of Comparative Example 2, are confirmed to exhibit significantly low resistivity at a thickness of 5 nm or less. Therefore, it is anticipated that applying the alloy layer of the stacked structures according to Examples to a trench-type wiring structure with a reduced (downscaled) line width will result in a low resistivity value.

### Evaluation 3: Oxidation Resistance of Stacked Structure

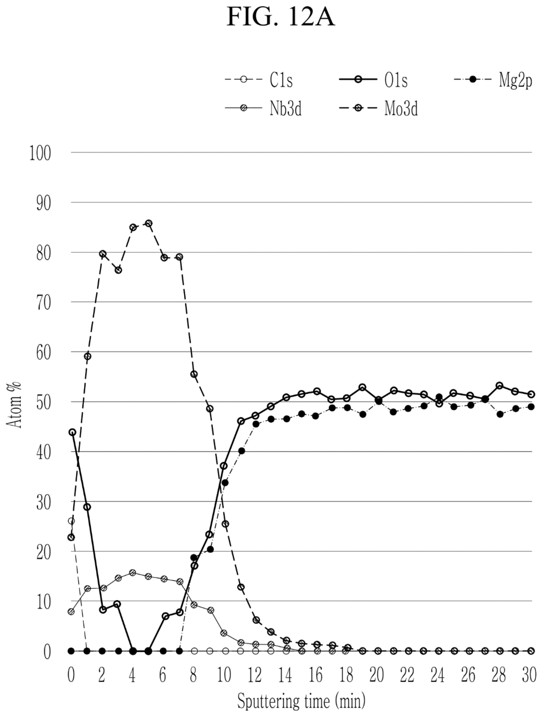

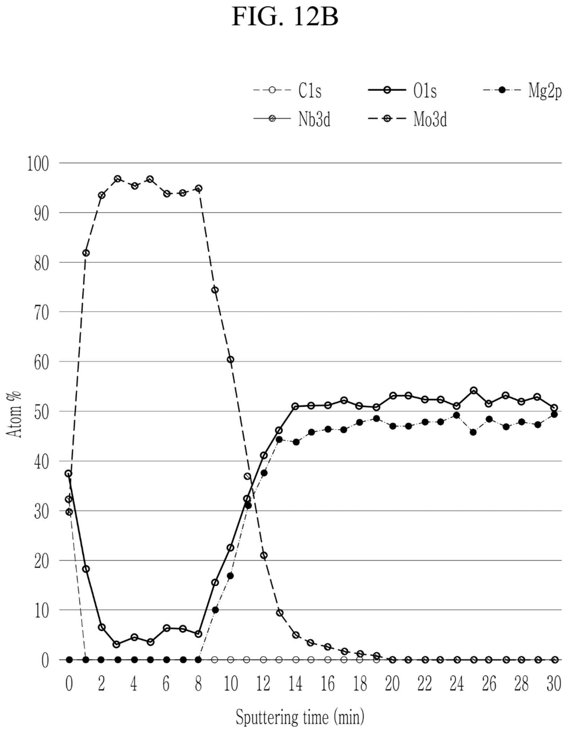

The stacked structures of Example 3 and Comparative Example 1 are subjected to XPS (X-ray Photoelectron Spectroscopy) analysis, and the results are shown in FIGS. 12A and 12B. FIGS. 12A and 12B are graphs showing the XPS analysis results of the stacked structures according to Example 3 and Comparative Example 1, respectively. Referring to FIG. 12A and FIG. 12B, the stacked structure of Example 3, compared to that of Comparative Example 1, is confirmed to have a section where no oxygen exists. Accordingly, the stacked structure of Example 3 has a section where there is no oxide layer, which confirms excellent oxidation resistance.

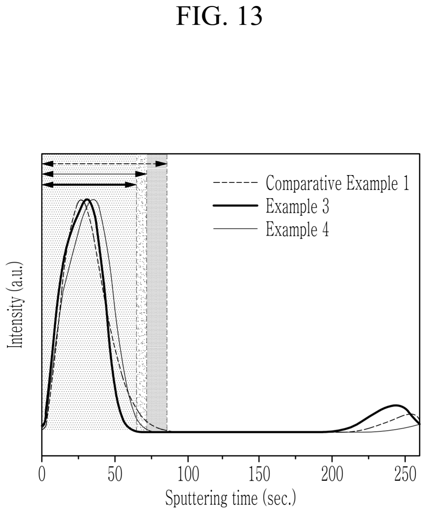

The stacked structures of Examples 3 and 4 and Comparative Example 1 are subjected to SIMS (Secondary Ion Mass Spectrometry) analysis to check whether or not an oxide layer is formed, and the results are shown in FIG. 13. The SIMS analysis is performed by using SIMS analysis equipment (manufacturer: ION-TOF GmbH, Muenster, model name: ToF-SIMS). FIG. 13 is a graph showing the SIMS analysis results of the stacked structures of Examples 3 and 4 and Comparative Example 1. In the graph of FIG. 13, "0" of a horizontal axis means the surface of the stacked structure. The profile of FIG. 13 shows the analysis result of MoO₂⁻, wherein MoO₂⁻ is less detected in the stacked structures of Examples 3 and 4 than in that of Comparative Example 1. Accordingly, the stacked structures of Examples 3 and 4 exhibit a superior oxidation structure and consequently superior oxidation resistance to that of Comparative Example 1.

While the embodiments of the present disclosure have been described in detail, it is to be understood that the disclosure is not limited to the disclosed embodiments, but on the contrary, is intended to cover various modifications and equivalent arrangements included within the scope of the appended claims.

## Claims

1. An interconnect structure, comprising
a dielectric layer having a trench structure; and
a conductive wiring layer filled inside the trench structure,
wherein the conductive wiring layer comprises an alloy represented by Chemical Formula 1:
Chemical Formula 1 M¹₁₋ₓM²ₓ
wherein, in Chemical Formula 1, M¹ is one of molybdenum, tungsten, or a combination thereof, M² is one of niobium, vanadium, or a combination thereof, and x is less than about 0.5.

2. An interconnect structure, comprising
a dielectric layer having a trench structure;
a conductive wiring layer filled inside the trench structure; and
at least one of a barrier layer between the dielectric layer and the conductive wiring layer or a capping layer on the conductive wiring layer, wherein the barrier layer and capping layer comprises an alloy represented by Chemical Formula 1:
Chemical Formula 1 M¹₁₋ₓM²ₓ
wherein, in Chemical Formula 1, M¹ is one of molybdenum, tungsten, or a combination thereof, M² is one of niobium, vanadium, or a combination thereof, and x is less than about 0.5.

3. The interconnect structure of claim 1 or 2, wherein
in Chemical Formula 1, x is less than or equal to about 0.4.

4. The interconnect structure of one of claims 1 to 3, wherein
the alloy represented by Chemical Formula 1 has a body-centered cubic crystal structure.

5. The interconnect structure of one of claims 1 to 4, wherein
the alloy represented by Chemical Formula 1 is a solid-solution alloy.

6. The interconnect structure of one of claims 1 to 5, wherein
the alloy represented by Chemical Formula 1 has a cohesive energy of greater than or equal to about 6.0 electron volts per atom.

7. The interconnect structure of one of claims 1 to 6, wherein
the alloy represented by Chemical Formula 1 has a figure of merit of less than or equal to about 5.0 x 10⁻¹⁶ ohm-meter squared.

8. The interconnect structure of one of claims 1 to 7, wherein
the interconnect structure further comprises a seed layer having a body-centered cubic crystal structure on a lower surface of the trench structure.

9. The interconnect structure of claim 8, wherein
the seed layer has a thickness of less than or equal to about 3 nanometers.

10. The interconnect structure of one of claims 1 to 9, wherein
the trench structure has a width of less than or equal to about 10 nanometers and an aspect ratio of greater than or equal to about 3.

11. The interconnect structure of one of claims 2 to 10, wherein
the barrier layer is disposed on both sides, a lower surface, or both of the conductive wiring layer.

12. An electronic device, comprising
a plurality of components,
wherein the plurality of components comprises a transistor, a capacitor, a diode, a resistor, or a combination thereof, and an interconnect structure disposed at a connection portion between the plurality of components or at the connection portion within each of the plurality of components,
wherein the interconnect structure comprises
a dielectric layer having a trench structure; and
a conductive wiring layer comprising an alloy represented by Chemical Formula 1 filled inside the trench structure,
wherein the interconnect structure further comprises at least one of a barrier layer between the dielectric layer and the conductive wiring layer or a capping layer on the conductive wiring layer,
at least one of the conductive wiring layer, the barrier layer, or the capping layer comprises an alloy represented by Chemical Formula 1:
Chemical Formula 1 M¹₁₋ₓM²ₓ
wherein, in Chemical Formula 1, M¹ is one of molybdenum, tungsten, or a combination thereof, M² is one of niobium, vanadium, or a combination thereof, and x is less than about 0.5.

13. The electronic device of claim 12, wherein
the electronic device comprises a transistor, a capacitor, a diode, or a resistor.

14. An electronic apparatus comprising the interconnect structure according to one of claims 1 to 11.
